# EUROPEAN PATENT APPLICATION

(11) **EP 1 624 339 A1**
(43) Date of publication of application: **08.02.2006**
(21) Application number: 05016307.0
(22) Date of filing: 27.07.2005
(51) Int. Cl.: G03F 7/004, G03F 7/033

(54) **Photosensitive dielectric compositions, tapes, and method of application of a dielectric sheet using the same**

(30) Priority: 03.08.2004 US 910126
(71) Applicant: E.I. du Pont de Nemours and Company, Wilmington, DE 19898 (US)
(72) Inventor: Bidwell, Larry Alan, Wake Forest North Carolina 27587 (US); Taylor, Barry Edward, Wake Forest North Carolina 27587 (US)
(74) Representative: Towler, Philip Dean

(57) **Abstract**

A castable photosensitive dielectric composition, a conformable photosensitive green dielectric tape suitable for hot roll lamination, methods of application of the unique compositions and tapes, method of forming an electronic circuit, and multilayered electronic circuit and structures utilizing and/or formed from said compositions and tapes.

## Description

### FIELD OF THE INVENTION

The present invention relates to a method of application of a ceramic-containing dielectric sheet and photosensitive dielectric compositions used therein. In particular, one embodiment of the invention further relates to a method of forming a ceramic multilayer circuit and photosensitive dielectric tape composition(s) useful in said method.

### BACKGROUND OF THE INVENTION

While the present invention may be useful in a multitude of applications such as, electronic circuits in general, multilayer ceramic interconnect circuit boards, pressure sensors, fuel cells, customization of ceramic objects, and the creation of fired patterned art work, it is especially useful in the manufacture of multilayer interconnect circuit boards. The background of the invention is described below with reference to ceramic interconnect circuit boards, as a specific example of the prior art.

An interconnect circuit board is a physical realization of electronic circuits or subsystems made from a number of small circuit elements that are electrically and mechanically interconnected. It is frequently desirable to combine these diverse type electronic components in an arrangement so that they can be physically isolated and mounted adjacent to one another in a single compact package and electrically connected to each other and/or to common connections extending from the package.

Complex electronic circuits generally require that the circuit be constructed of several layers of conductors separated by insulating dielectric layers. The conductive layers are interconnected between levels by electrically conductive pathways, called vias, through a dielectric layer. Such a multilayer structure allows a circuit to be more compact and have denser circuit functionality.

One well-known method for constructing a multilayer interconnect circuit is by sequentially printing and firing thick film conductors and insulating dielectrics through a patterned screen mesh onto a rigid ceramic insulative substrate. The rigid substrate provides mechanical support, dimensional stability, and facilitates registration of the patterned thick film conductor and dielectric layers. However, the thick film process is disadvantageous in that printing through a screen mesh can result in pinholes or voids in the dielectric layer which can cause shorting between conductor layers. If the thick film dielectric is formulated to allow sufficient flow of the paste during the printing operation and thus to minimize the tendency to form pinholes, then the maintenance of small vias is likely to be compromised by the flow of dielectric paste into the via hole. Also, the repetitive printing and firing steps for each layer are time consuming and expensive.

Another method for constructing multilayer interconnect circuits employs thick film conductors and green dielectric sheets comprising inorganic dielectric powders dispersed in an organic polymer binder. Vias are formed in the individual sheets by mechanical punching or laser drilling. The dielectric sheets containing vias are laminated in registry to a dimensionally stable insulative substrate on which a conductor pattern has been formed and the dielectric is fired. Next the vias are metallized and a second conductor layer is formed on the exposed surface of the dielectric layer in registry with the vias. The sequential steps of adding dielectric tape layers and metallizations and firing (i.e., each layer is fired before application of the next layer) are repeated until the desired circuit is obtained. Processes utilizing green dielectric sheets sequentially laminated by conventional press lamination methods to dimensionally stable substrates are further described in U.S. Patent Nos. 4,655,864 and U.S. 4,654,552. Using dielectric in sheet form avoids the printing and flow drawbacks of the thick film paste dielectric. But, via formation by mechanical and laser means is time consuming, as well as expensive. Also, registration of the via arrays in the different sheets is difficult and the mechanical punch stresses and deforms the sheet surrounding the via.

EP 0589241 to Suess discloses a photosensitive ceramic dielectric sheet composition and the manufacture of multilayer interconnect circuits using said sheet. The sheet is self-supporting and developable in a dilute aqueous solution of Na₂CO₃. The composition of Suess teaches that a "small amount of plasticizer, relative to the binder polymer, serves to lower the glass transition temperature (Tg) of the binder polymer, and furthermore, that the use of such materials should be minimized in order to reduce the amount of organic materials which must be removed when the films cast therefrom are fired." While Suess provides a photosensitive tape composition for use in multilayer interconnect circuits, it does not provide a method for high-speed manufacturing.

Furthermore, the prior art teaches various methods for control of xy shrinkage during the formation of multilayer circuits as described in U.S. 4,654,095 to Steinberg, U.S. 5,085,720 to Mikeska, U.S. 6,139,666 to Fasano, US 6,205,032 to Shepherd, and US 5,085,720. However, each of these methods utilizes conventional press lamination (including uniaxial, isostatic) methods and do not allow for high speed manufacturing. Therefore, a need exists for a ceramic dielectric sheet composition which may be used in a novel high speed manufacturing method, while still controlling x,y shrinkage.

Despite the advances in dielectric compositions and methods of multilayer interconnect circuit manufacturing, a need still exists for a dielectric composition and attendant methods for manufacturing multilayer interconnect circuits which combines the following advances including (1) high speed manufacturing method through (a) quick patterning with a via and/or circuit array after lamination, (b) superior photosensitive dielectric composition sheet (or tape) with fast development and exposure times; (c) hot roll lamination processing; (d) superior adhesion characteristics; and (e) conventional furnace firing; while (2) controlling x,y shrinkage to zero or nearly zero; (3) providing a lead-free and/or cadmium-free sheet composition; (4) providing the ability to replace functional layers if a mistake is made; and (5) providing a dielectric composition with superior dielectric properties.

The inventors of the present invention have provided such a superior method of multilayer interconnect circuit manufacturing, dielectric sheet composition(s) and dielectric sheet. Similarly, it is possible to provide novel and otherwise difficult to achieve customization of suitable dimensionally stable substrates using the compositions and methods described in the present invention.

### SUMMARY OF THE INVENTION

The present invention provides castable photosensitive dielectric composition(s), conformable photosensitive green dielectric tape(s) suitable for hot roll lamination, methods of application of the unique compositions and tapes, methods of forming an electronic circuit, and multilayered electronic circuit and structures utilizing and/or formed from said compositions and tapes.

In particular, the present invention is directed to a method for the application of a conformable photosensitive green dielectric tape to a dimensionally stable substrate comprising the sequential steps of: (a) providing a dimensionally stable substrate; (b) providing the conformable photosensitive green dielectric tape as described above; (c) hot roll laminating the conformable photosensitive green tape of (b) to the substrate of (a); (d) exposing the photosensitive green tape of (c) in a desired pattern thus creating polymerized and unpolymerized areas; and (e) developing the unexposed tape of (d) thus removing the unpolymerized areas and forming a desired pattern. The method of application may further comprise the step of firing said desired pattern and substrate.

### BRIEF DESCRIPTION OF THE DRAWINGS

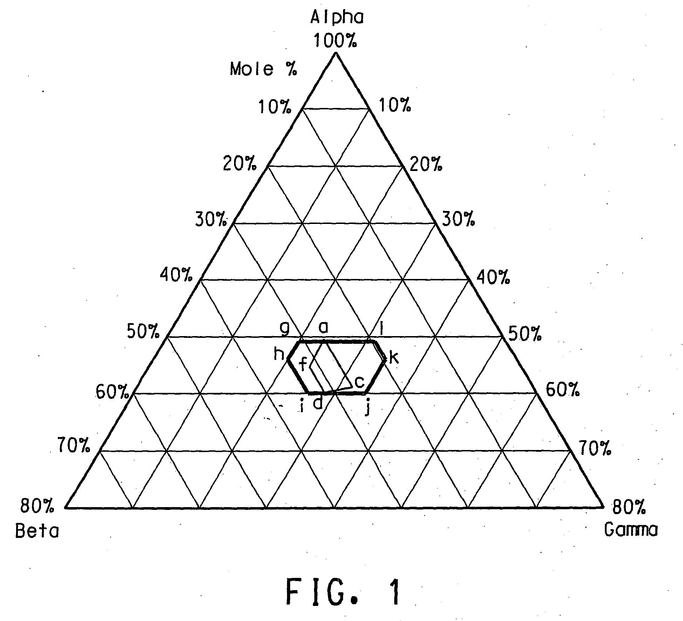

Figure 1 is a ternary phase diagram showing the compositional range for the glass contained in the substrate of one embodiment of the present invention wherein the substrate contains a dielectric paste or tape containing CaO, MgO and/or SrO as alkaline earth modifiers.

### DETAILED DESCRIPTION OF THE INVENTION

The present invention discloses a new and improved composition(s), processes and methods for manufacturing a multitude of products. In particular the present invention may be utilized in the manufacture of multilayer circuits. This new method increases manufacturing speed and provides a superior product through the use of a novel photosensitive dielectric sheet composition in a novel hot roll lamination process, while still minimizing x,y shrinkage to nearly zero.

In particular, the present invention teaches a castable photosensitive dielectric composition comprising an admixture of: (a) finely divided particles of inorganic binder; dispersed in an organic composition comprising: (b) an organic polymeric binder comprising a copolymer, interpolymer or mixtures thereof, wherein each copolymer or interpolymer comprises (1) a nonacidic comonomer comprising a C₁₋₁₀ alkyl acrylate, C₁₋₁₀ alkyl methacrylate, styrenes, substituted styrenes, or combinations thereof and (2) an acidic comonomer comprising ethylenically unsaturated carboxylic acid containing moiety, the copolymer, interpolymer or mixture having an acid content of at least 15% by weight; (c) plasticizer wherein the ratio of plasticizer to polymer binder is in the range of 4:23 to 7:9; (d) a photoinitiator; (e) photohardenable monomer; dissolved in (f) an organic solvent, the composition upon imagewise exposure to actinic radiation being developable in a dilute aqueous basic solution containing 0.4 - 2.0 wt.% of base. The composition may further comprise ceramic solids.

The present invention further teaches a conformable photosensitive green dielectric tape suitable for hot roll lamination comprising an admixture of: (a) finely divided particles of inorganic binder; dispersed in an organic composition comprising: (b) an organic polymeric binder comprising a copolymer, interpolymer or mixtures thereof, wherein each copolymer or interpolymer comprises (1) a nonacidic comonomer comprising a C₁₋₁₀ alkyl acrylate, C₁₋₁₀ alkyl methacrylate, styrenes, substituted styrenes, or combinations thereof and (2) an acidic comonomer comprising ethylenically unsaturated carboxylic acid containing moiety, the copolymer, interpolymer or mixture having an acid content of at least 15% by weight; (c) plasticizer wherein the ratio of plasticizer to polymer binder is in the range of 4:23 to 7:9; (d) a photoinitiator; and (e) photohardenable monomer; the composition upon imagewise exposure to actinic radiation being developable in a dilute aqueous base solution containing 0.4-2.0 wt.% base. The dielectric tape may further comprise ceramic solids.

Furthermore, the present invention provides a method for the application of a conformable photosensitive green dielectric tape to a dimensionally stable substrate comprising the sequential steps of: (a) providing a dimensionally stable substrate; (b) providing the conformable photosensitive green dielectric tape as described above; (c) hot roll laminating the conformable photosensitive green tape of (b) to the substrate of (a); (d) exposing the photosensitive green tape of (c) in a desired pattern thus creating polymerized and unpolymerized areas; and (e) developing the unexposed tape of (d) thus removing the unpolymerized areas and forming a desired pattern. The method of application may further comprise the step of firing said desired pattern and substrate.

The present invention also discloses a method of forming an electronic circuit comprising the steps of: (a) providing a dimensionally stable substrate; (b) providing the conformable photosensitive green dielectric tape as described above; (c) hot roll laminating the photosensitive green tape of (b) to the substrate of (a); (d) exposing the photosensitive green tape of (c) in a desired pattern thus creating polymerized and unpolymerized areas; and (e) developing the unexposed film of (d) thus removing the unpolymerized areas and forming a desired pattern. The electronic circuit formed may be a multilayered electronic circuit.

The present invention further provides a structure comprising a substrate and at least one layer of the conformable green dielectric tape of as described above, wherein said tape has been processed to volatilize the organic binder and sinter the glass composition. The structure may further comprise one or more metallized layers.

The components of the novel dielectric composition(s) are described below.

### INORGANIC BINDER

The inorganic binder ideally should be non-reactive, but in reality, may be reactive with respect to the other materials in the system. It is selected to possess the desired electrically insulative characteristics and have the appropriate physical properties relative to any ceramic solids (fillers) in the body.

The particle size and particle size distribution of the inorganic binder and any ceramic solids are not narrowly critical, and the particles will usually be between 0.5 and 20 µm in size. The D₅₀ (median particle size) of frit is preferably in the range of, but not limited to, 1 to 10 µm and more preferably 1.5 to 5.0 µm.

The basic physical properties that are preferred for the inorganic binder are (1) that it have a sintering temperature below that of any ceramic solids in the body, and (2) that it undergo viscous phase sintering at the firing temperatures used.

The glass of the present composition is a family of amorphous, partially crystallizable alkaline earth zinc silicate glass compositions. These compositions are disclosed in U.S. Patent No. 5,210,057 to Haun et al, which is incorporated herein.

Haun et al. discloses an amorphous partially crystallizable alkaline earth zinc silicate glass consisting essentially of a composition falling within the area defined on a weight points g-l of Figure 1 of the drawing, in which: (1) alpha is SiO₂ in admixture with a glass former or conditional glass former selected from the group consisting of no more than 3% Al₂O₃, 6% HfO2, 4% P2O₅, 10% TiO₂, 6% ZrO2 and mixtures thereof, with the proviso that the composition contains at least 0.5% ZrO2; (2) beta is an alkaline earth selected from CaO, SrO, MgO, BaO and mixtures thereof, with the proviso that the composition contain no more than 15% MgO and no more than 6% BaO; and (3) gamma is ZnO, the loci of points g-l being as follows: point g - Alpha 48.0, Beta 32.0, Gamma 20.0; point h - Alpha 46.0, Beta 34.0, Gamma 20.0; point i - Alpha 40.0, Beta 34.0, Gamma 26.0; point j - Alpha 40.0, Beta 24.0, Gamma 36.0; point k - Alpha 46.0, Beta 18.0, Gamma 36.0; point k - Alpha 46.0, Beta 18.0, Gamma 36.0; point I - Alpha 48.0, Beta 19.0, Gamma 33.0.

Haun et al. further discloses the glass described in the above paragraph in which alpha contains Al₂O₃ up to 3% plus 2/3 of the % of BaO if any; and constitutes with respect to the total glass composition no more than 48% plus the % of BaO; beta contains up to 6% BaO and constitutes with respect to the total glass composition no more than 33% plus ½ of the % of BaO if any; and gamma constitutes no more than 36% minus 1/3 of the % of BaO if any.

Haun et al. further discloses the glasses described above which further contains both Al₂O₃ and P2O₅, added as AlPO₄ or AlP₃O₉.

The glass utilized in one Pb-free, Cd-free embodiment of the present invention relates to an alkali-alkaline earth-alumino- borosilicate glass composition comprising, in mole %, 46-66% SiO₂, 3-9% Al₂O₃, 5-9% B₂O₃, 0-8% MgO, 1-6% SrO, 11-22% CaO, and 2-8% M wherein M is selected from oxides of the group of alkali elements and mixtures thereof. Alkali elements are found in group IA of the periodic table. For example, the alkali element oxide may be selected from Li₂O, Na₂O, K₂O and mixtures thereof. The molar ratio of SrO / (Ca + MgO) is between about 0.06 to about 0.45. This ratio range is necessary to assure compatibility properties with conductor materials used in conjunction with the LTCC tape of this invention.

In this Pb-free and Cd-free embodiment, the content of alkali and alkaline earth modifier in the glass is believed to increase the thermal expansion coefficient of glass while providing glass viscosity reduction critical to processing LTCC tape materials. Although the alkaline earth oxide, BaO, could be used to make an LTCC tape, it is found to reduce the chemical resistance, due to its ease of leaching in low pH solutions. For this reason, superior chemical resistance is found for alkaline earth modifier constituents within the ratio limits and mole percents defined above. Strontium oxide imparts superior solderability and low conductor resistivity in conductor material systems applied to outer layers of the tape. The content of strontium oxide in the glass, provides this improved conductor performance when present in the glass at levels including and exceeding 1 mole%. Data show that levels of 1 to 6 mole% provide improved conductor performance. A preferred level of strontium oxide is 1.8 - 3.0 mole%. The existence of the alkali oxides in the glass when used in a green tape improves the sensitivity of the glass to thermal process conditions by controlling the densification and crystallization behavior of the tape. The crucial role of the alkali addition is to provide required flow and densification characteristics to the tape at a desired firing temperature. It performs the function of glass viscosity reduction without affecting required physical and electrical performance of the tape. The type and amounts of alkali ions used to modify the viscosity properties of the glass also have an effect on the electrical loss characteristics of the tape made from the glass.

The glasses described herein may contain several other oxide constituents. For instance, ZrO₂, GeO₂, and P₂O₅ maybe partially substituted for SiO₂ in the glass as follows, in mole % based on total glass composition: 0-4 mole% ZrO₂, 0-2 mole% P₂O₅, and 0-1.5 mole% GeO₂. Additionally 0-2.5 mole%, based on total glass composition, CuO may be partially substituted for the alkali and/or the alkaline earth constituents. A factor for the suitability of an LTCC tape formulation utilizing glass as a constituent is the required compatibility with conductors, and passive materials utilized as circuit components within and on the surface of the tape. This includes physical constraints such as suitable thermal expansion and the attainment of suitable levels of density and strength of the tape, the latter of which is enabled by the suitability of the glass viscosity to provide a tape in the required thermal processing temperature range.

The glasses described herein are produced by conventional glass making techniques. More particularly, the glasses may be prepared as follows. Glasses are typically prepared in 500 -1000 gram quantities. Typically, the ingredients are weighted, then mixed in the desired proportions, and heated in a bottom-loading furnace to form a melt in a platinum alloy crucible. Heating is typically conducted to a peak temperature (1500-1550°C) and for a time such that the melt becomes entirely liquid and homogeneous. The glass melts are then quenched by pouring on the surface of counter rotating stainless steel rollers to form a 10-20 mil thick platelet of glass or by pouring into a water tank. The resulting glass platelet or water quenched frit is milled to form a powder with its 50% volume distribution set between 1 - 5 microns. The resulting glass powders are formulated with filler and medium into thick film pastes or castable dielectric compositions.

The glass when incorporated into a tape is compatible with co-fired thick film conductor materials. The glass in the tape does not flow excessively upon firing. This is due to the partial crystallization of the glass, which is initiated by the reaction between a ceramic filler, typically Al₂O₃, and the glass. The glass, which remains following the partial crystallization, is changed to a more refractory glass. This eliminates staining of the tape with the conductor material and allows solder wetting or chemical plating of the thick film conductor material. Solder wetting is an important feature to allow connection of the ceramic circuit to external wiring such as on a printed circuit board. If chemical plating of thick film conductors is applied to surface layers of the tape, low pH plating baths can release ions from the surface of the tape contaminating the plating bath. For this reason, the glass found in the tape minimizes the release of glass constituents by chemical corrosion in reduced pH solutions. Additionally, the glass found in the tape also minimizes the release of glass constituents by chemical corrosion in strong basic solutions.

### OPTIONAL CERAMIC SOLIDS

The ceramic solids are optional in the dielectric composition of the invention. When added, they are selected to be chemically inert with respect to the other materials in the system, possess the desired electrically insulative properties and to have the appropriate physical properties relative to the inorganic binder and photosensitive components of the compositions. Basically, the solids are fillers, which adjust properties such as thermal expansion and dielectric constant.

The physical properties most desirable of the ceramic solids in the dielectric are (1) that they have sintering temperatures above the sintering temperatures of the inorganic binder, and (2) that they do not undergo sintering during the firing step of the invention. Thus, in the context of this invention, the term "ceramic solids: refers to inorganic materials, usually oxides, which undergo essentially no sintering and have a limited tendency to dissolve in the inorganic binder under the conditions of firing to which they are subjected in the practice of the invention.

Subject to the above criteria, virtually any high melting inorganic solid can be used as the ceramic solids component of dielectric tape to modulate the electrical dielectric performance (e.g., K, d.f., TCC) as well as the physical characteristics of the dielectric after firing. Examples of possible ceramic filler additives include Al₂O₃, ZrO₂, TiO₂, BaTiO₃, CaTiO₃, SrTiO₃, CaZrO₃, SrZrO₃, BaZrO₃, CaSnO₃, BaSnO₃, PbTiO₃, metal carbides such as silicon carbide, metal nitrides such as aluminum nitride, minerals such as mullite and kyanite, cordierite, zirconia, forsterite, anorthite, and various forms of silica or mixtures thereof.

Ceramic solids may be added to the dielectric composition in an amount of 0-50 wt. % based on solids. Depending on the type of filler, different crystalline phases are expected to form after firing. The filler can control dielectric constant and thermal expansion properties. For example, the addition of BaTiO₃ can increase the dielectric constant significantly.

Al₂O₃ is the preferred ceramic filler since it reacts with the glass to form an Al-containing crystalline phase. Al₂O₃ is very effective in providing high mechanical strength and inertness against detrimental chemical reactions. Another function of the ceramic filler is rheological control of the entire system during firing. The ceramic particles limit flow of the glass by acting as a physical barrier. They also inhibit sintering of the glass and thus facilitate better bumout of the organics. Other fillers, α-quartz, CaZrO₃, mullite, cordierite, forsterite, zircon, zirconia, BaTiO₃, CaTiO₃, MgTiO₃, SiO₂, amorphous silica or mixtures thereof may be used to modify tape performance and characteristics.

In the formulation of tape compositions, the amount of glass relative to the amount of ceramic (filler) material is important. A filler range of 10-40% by weight is considered desirable in that the sufficient densification is achieved. If the filler concentration exceeds 50% by wt., the fired structure is not sufficiently densified and is too porous. Within the desirable glass/filler ratio, it will be apparent that, during firing, the liquid glass phase will become saturated with filler material.

For the purpose of obtaining higher densification of the composition upon firing, it is important that the inorganic solids have small particle sizes. In particular, substantially all of the particles should not exceed 15 µm and preferably not exceed 10 µm. Subject to these maximum size limitations, it is preferred that at least 50% of the particles, both glass and ceramic filler, be greater than 1.0 µm and less than 6 µm.

The specific type of glass chemistry is not critical to the embodiment of this invention, and can contain a wide range of possible constituents, depending on the specific application where the photosensitive tape is to be used. Several glass compositions are detailed in Table 1 below. For example, in situations where a lead based glass would be acceptable, a glass such as Glass A might be incorporated. For applications where lead-containing glass is not acceptable, but where high reliability dielectric properties are still needed after firing the tape composition at 850 degrees C, a glass of the type "B" might be incorporated. Still further to the broad potential applications where the embodiment might be applied, Glass C describes a chemistry that could be used in applications where low firing temperatures are needed because of the type of substrate to be used, i.e., such as soda lime glass substrates.

**Table 1: Examples of Several Embodiments of Glass Compositions and Solids Compositions of the Present Invention**

| Ingredients | Solids A | Solids B | Solids C |
|---|---|---|---|
| Glass A | 27.6 | 0 | 0 |
| Glass B | 0 | 42.2 | 0 |
| Glass C | 0 | 0 | 49 |
| Alumina | 21.7 | 18.9 | 16.3 |
| Cobalt Aluminate | 0.3 | 0.2 | 0 |
| | | | |

| Ingredients | Glass A | Glass B | Glass C |
|---|---|---|---|
| PbO | 17.2 | 0 | 0 |
| SiO2 | 56.5 | 38.64 | 7.11 |
| B2O3 | 4.5 | 0 | 8.38 |
| Na2O | 2.4 | 0 | 0 |
| K2O | 1.7 | 0 | 0 |
| MgO | 0.6 | 0 | 0 |
| CaO | 8 | 14.76 | 0.53 |
| Al2O3 | 9.1 | 0 | 2.13 |
| BaO | 0 | 12.66 | 0 |
| Zr02 | 0.0 | 2.5 | 0.0 |
| ZnO | 0 | 29.97 | 12.03 |
| P2O5 | 0 | 1.45 | 0 |
| Bi2O3 | 0 | 0 | 69.82 |

Tables 2 and 3 detail the typical Particle Size Distribution (PSD) in microns for the Glass Powders "A" and "B" in Table 1.

**Table 2: Glass A PSD, microns (typical)**

| D(10) | D(50) | D(90) | D(100) |
|---|---|---|---|
| 0.774 | 2.118 | 4.034 | 9.25 |
| 0.832 | 2.598 | 5.035 | 11.00 |

**Table 3: Glass B PSD, microns (typical)D10 0.95 - 1.05**

| | |
|---|---|
| D(10) | 0.95-1.05 microns |
| D(50) | 2.4 - 3.0 microns |
| D(90) | 5.0 - 6.5 microns |

### ORGANIC CONSTITUENTS

### Polymeric Binder

The organic constituents in which the amorphous glass powder and optional ceramic inorganic solid powders are dispersed is comprised of one or more acrylic-based polymeric binders, one or more photosensitive acrylic-based monomers which will cross link and provide differentiation after exposure to UV actinic light, one or more initiator which facilitates the photo process and one or more plasticizers, all of which are dissolved in a volatile organic solvent. The "slurry" or combination of all the organic ingredients and the inorganic powders comprised of the amorphous glass powder and the optional inorganic "filler' additives is commonly referred to as the "slip" by those familiar in the art and, optionally, other dissolved materials such as release agents, dispersing agents, stripping agents, antifoaming agents, stabilizing agents and wetting agents.

Once the wet "slip" has been coated on to a suitable backing material at the desired thickness and has been dried to get rid of all low boiling solvent, the photosensitive "tape" results.

The polymer binder(s) are critical to the composition of the present invention. Additionally, the polymer binders of the present invention render the tape to be developable in an aqueous base solution of 0.4%-2.0 weight % base (Na₂CO₃ or K₂CO₃), allowing high resolution of features exposed to the UV actinic radiation, and furthermore, giving good green strength, flexibility and lamination properties of the cast tape. The polymer binders are made of copolymer, interpolymer or mixtures thereof, wherein each copolymer or interpolymer comprises (1) a nonacidic comonomer comprising a C₁₋₁₀ alkyl acrylate, C₁₋₁₀ alkyl methacrylate, styrenes, substituted styrenes, or combinations thereof and (2) an acidic comonomer comprising ethylenically unsaturated carboxylic acid containing moiety, the copolymer, interpolymer mixture having an acid content of at least 15% by weight. The mixture may comprise copolymers, interpolymers or both. The acidic polymer binder must be developed by a solution containing a basic component.

The presence of acidic comonomer components in the composition is important in this technique. The acidic functional group provides the ability to be developed in aqueous bases such as aqueous solutions of 0.4-2.0 weight% sodium carbonate or potassium carbonate. When acidic comonomers are present in concentrations of less than 10%, the composition is not washed off completely with an aqueous base. When the acidic comonomers are present at concentrations greater than 30%, the composition is less resistant under development conditions and partial development occurs in the imaged portions. Appropriate acidic comonomers include ethylenically unsaturated monocarboxylic acids such as acrylic acid, methacrylic acid, or crotonic acid and ethylenically unsaturated dicarboxylic acids such as fumaric acid, itaconic acid, citraconic acid, vinyl succinic acid, and maleic acid, as well as their hemiesters, and in some cases their anhydrides and their mixtures.

It is preferred that the nonacidic comonomers constitute at least 50 wt% of the binder polymer. Although not preferable, the nonacidic portion of the polymer binder can contain up to about 50 wt. % of other nonacidic comonomers as substitutes for the alkyl acrylate, alkyl methacrylate, styrene, or substituted styrene portions of the polymer. Examples include acrylonitrile, vinyl acetate, and acrylamide. However, because it is more difficult for these to completely burn out, it is preferable that less than about 25 wt. % of such monomers in the total polymer binder are used.

The use of single copolymers or combinations of copolymers as binders are recognized as long as each of these satisfies the various standards above. In addition to the above copolymers, adding small amounts of other polymer binders is possible. For examples of these, polyolefins such as polyethylene, polypropylene, polybutylene, polyisobutylene, and ethylene-propylene copolymers, polyvinyl alcohol polymers (PVA), polyvinyl pyrrolidone polymers(PVP), vinyl alcohol and vinyl pyrrolidone copolymers, as well as polyethers that are low alkylene oxide polymers such as polyethylene oxide can be cited.

The polymers described herein can be produced by those skilled in the art of acrylate polymerization by commonly used solution polymerization techniques. Typically, such acidic acrylate polymers are produced by mixing α- or β-ethylenically unsaturated acids (acidic comonomers) with one or more copolymerizable vinyl monomer (nonacidic comonomers) in a relatively low-boiling-point (75-150°C) organic solvent to obtain a 10-60% monomer mixture solution, then polymerizing the monomers by adding a polymerization catalyst and heating the mixture under normal pressure to the reflux temperature of the solvent. After the polymerization reaction is essentially complete, the acidic polymer solution produced is cooled to room temperature.

A reactive molecule, a free radical polymerization inhibitor and a catalyst are added to the cooled polymer solution described above. The solution is stirred until the reaction is complete. Optionally, the solution may be heated to speed up the reaction. After the reaction is complete and the reactive molecules are chemically attached to the polymer backbone, the polymer solution is cooled to room temperature, samples are collected, and the polymer viscosity, molecular weight, and acid equivalents are measured.

### Plasticizer

Plasticizer is essential to the present invention. The use of the plasticizer in the present invention is optimized to satisfy several properties of the tape both before, during and after the hot roll lamination process has occurred to allow for hot roll lamination by providing a flexible conformal tape composition. If too much plasticizer is used, the tape will stick together. If too little plasticizer is used, the tape may chip during processing. The plasticizer, in combination with the polymer binder of the composition, contributes to the desired adhesive properties of the tape, thus allowing the tape film to adhere to the substrate upon hot roll lamination.

Additionally, the plasticizer serves to lower the glass transition temperature (Tg) of the binder polymer. The ratio of plasticizer to polymer binder is in the range of 4:23 to 7:9. The plasticizer is present in the total composition in 1-12 wt. %, more preferably 2-10%, and most preferably, 4 - 8% by weight of the total dried tape composition.

The choice of plasticizers, of course, is determined primarily by the polymer that needs to be modified. Among the plasticizers which have been used in various binder systems are diethyl phthalate, dibutyl phthalate, dioctyl phthalate, butyl benzyl phthalate, alkyl phosphates, polyalkylene glycols, glycerol, poly(ethylene oxides), hydroxyethylated alkyl phenol, dialkyldithiophosphonate and poly(isobutylene). Of these, butyl benzyl phthalate is most frequently used in acrylic polymer systems because it can be used effectively in relatively small concentrations. Preferred plasticizers are BENZOFLEX® 400 as well as BENZOFLEX® P200 manufactured by the Velsicol Company, which are a polypropylene glycol dibenzoate, and polyethylene glycol dibenzoate, respectively.

### Photoinitiation System (Photoinitiator)

Suitable photoinitiation systems are those which are thermally inactive, but which generate free radicals upon exposure to actinic radiation at or below 185°C. "Actinic radiation" means light rays, violet and ultraviolet light, X-rays, or other radiations by which chemical changes are produced. Certain photo initiators, even though thermally inactive, can generate free radicals at a temperature of 185°C or lower under exposure to actinic radiation. Examples include substituted or non-substituted polynuclear quinones, compounds having two inner molecular rings in a conjugated carbon ring system, such as 9,10-anthraquinone, 2-methylanthraquinone, 2-ethylanthraquinone, 2-tert-butylanthraquinone, octamethylanthraquinone, 1,4-naphthoquinone, 9,10-phenanthraquinone, benz(a)anthracene-7,12-dione, 2,3-naphthacene-5,12-dione, 2-methyl-1,4-naphthoquinone, 1,4-dimethylanthraquinone, 2,3-dimethylanthraquinone, 2-phenylanthraquinone, 2,3-diphenylanthraquinone, retene quinone, 7,8,9,10-tetrahydronaphthacene-5,12-dione, and 1,2,3,4-tetrahydrobenz(a)anthracene-7,12-dione. U.S. Patent No. 2,760,863 disclosed some other useful optical initiators that are thermally active even at a temperature as low as 85°C. They are vicinal (vicinal) ketal donyl alcohols such as benzoin, and pivaloin, acyloin ethers such as benzoin methyl and ethyl ether, as well as α-hydrocarbon-substituted aromatic acyloins such as α-methylbenzoin, α-allylbenzoin, and α-phenylbenzoin.

The photoreductive dyes and reducing agents disclosed in U.S. Patent Nos. 2,850,445, 2,875,047, 3,097,096, 3,074,974, 3,097,097, 3,145,104, 3,427,161, 3,479,186, and 3,549,367, such as phenatine, oxatine, and Michler's ketone (Michler's ketone) of the quinone class, benzophenone, and 2,4,5-triphenylimidazole dimer having hydrogen suppliers can be used as the initiators. Also, the sensitizer disclosed in U.S. Patent No. 4,162,162 can be used together with the optical initiator and photopolymerization inhibitor. The content of the optical initiator varies. In one embodiment, the content of the optical initiator is in the range of 0.02 -12 weight % with respect to the total weight of the dried photopolymerizable tape film layer. In a further embodiment, the optical initiator is present in the range of 0.1-3 weight %, and in still a further embodiment the optical initiator is present in the range of 0.2-2 weight %. One particularly useful photo initiator for the practice of this embodiment is Irgacure® 369 manufactured by Ciba Specialty Chemicals.

### Photohardenable Monomer

The photocurable monomer component used in the present invention is formed with at least one addition polymerizable ethylene type of unsaturated compound having at least one polymerizable ethylene group.

This compound is made from free radicals, then grown into chains, which are subjected to addition polymerization to form a polymer. The monomer compound is non-gaseous. In other words, it has a boiling point of 100°C or higher and can be plasticized on an organic polymerizable binder.

Examples of appropriate monomers that can be used either alone or in combination with other monomers include t-butyl acrylate and methacrylate, 1,5-pentanediol diacrylate and dimethacrylate, N,N-dimethylaminoethyl acrylate and methacrylate, ethylene glycol diacrylate and dimethacrylate, 1,4-butanediol acrylate and methacrylate, diethylene glycol, diacrylate and dimethacrylate, hexamethylene glycol diacrylate and methacrylate, 1 ,3-propanediol diacrylate and dimethacrylate, decamethylene glycol diacrylate and methacrylate, 1,4-cyclohexanediol diacrylate and dimethacrylate, 2,2-dimethylolpropane diacrylate and dimethacrylate, glycerol diacrylate and dimethacrylate, tripropylene glycol diacrylate and dimethacrylate, glycerol triacrylate and trimethacrylate, trimethylolpropane triacrylate and trimethacrylate, pentaerythritol triacrylate, and methaacrylate, polyoxyethylated trimethylolpropane triacrylate and trimethacrylate, and the same compounds disclosed in U.S. Patent No. 3,380,381, 2,2-di(phydroxyphenyl)-propane diacrylate, pentaerythritol tetraacrylate and tetramethacrylate, 2,2-di-(p-hydroxyphenyl)-propanediacrylate, pentaerythritol tetraacrylate and tetramethacrylate, 2,2-di(p-hydroxyphenyl)-propanedimethaacrylate, triethylene glycol diacrylate, polyoxyethyl-1,2-di-(p-hydroxyphenyl)propane dimethacrylate, di-(3-methacryloxy-2-hydroxypropyl)ether of bisphenol-A, di-(3-acryloxy-2-hydroxypropyl)ether of bisphenol A, di(2-methaklyoxyethyl)ether of bisphenol-A, di(2-acryloxyethyl)ether of bisphenol-A, di-(3-methalkyloxy-2-hydroxypropyl)ether of 1,4-butanediol, triethylene glycol dimethacrylate, polyoxypropyl trimethylol propanetriacrylate, butylene glycol diacrylate and dimethacrylate, 1,2,4-butanetriol triacrylate and trimethacrylate, 2,2,4-trimethyl-1,3-pentanediol diacrylate and dimethacrylate, 1-phenylethylene-1,2-dimethacrylate, diallyl fumarate, styrene, 1,4-benzenediol dimethacrylate, 1 ,4-diisopropenylbenzene, and 1,3,5-triisopropenylbenzene.

It is also possible to use ethylene-type unsaturated compounds having a molecular weight of at least 300, such as the alkylene or polyalkylene glycol diacrylate manufactured from a C2-15 alkylene glycol or polyalklyene glycol having 1-10 ether bonds as well as the compounds disclosed in U.S. Patent No. 2,927,022, especially those compounds having multiple addition polymerizable ethylene bonds when they are present as the terminal bonds.

Preferable examples of the monomers include polyoxyethylated trimethylolpropane triacrylate and trimethacrylate, ethylated pentaerythritol triacrylate, trimethylol propane triacrylate and trimethacrylate, dipentaerythritol monohydroxy pentaacrylate, and 1,10-decanediol dimethyl acrylate.

Other preferable monomers include monohydroxypolycaprolactone monoacrylate, polyethylene glycol diacrylate (molecular weight: about 200), and polyethylene glycol 400 dimethacrylate (molecular weight: about 400). The content of the unsaturated monomer component is preferably in the range of 2-20 wt% of the total weight of the dried photopolymerizable tape film layer, more preferably 2-12% and most preferably, 2-7% of the dry tape film layer. One particularly useful monomer for the practice of this embodiment is CD582, also known as alkoxylated cyclohexane diacrylate, manufactured by Sartomer Company.

### Organic Solvent

The solvent component of the casting solution is chosen so as to obtain complete dissolution of the polymer and sufficiently high volatility to enable the solvent to be evaporated from the dispersion by the application of relatively low levels of heat at atmospheric pressure. In addition, the solvent must boil well below the boiling point or the decomposition temperature of any other additives contained in the organic medium. Thus, solvents having atmospheric boiling points below 150°C are used most frequently. Such solvents include acetone, xylene, methanol, ethanol, isopropanol, methyl ethyl ketone, ethyl acetate, 1,1,1-trichloroethane, tetrachloroethylene, amyl acetate, 2,2,4-triethyl pentanediol-1,3-monoisobutyrate, toluene, methylene chloride and fluorocarbons. Individual solvents mentioned above may not completely dissolve the binder polymers. Yet, when blended with other solvent(s), they function satisfactorily. This is well within the skill of those in the art. A particularly preferred solvent is ethyl acetate since it avoids the use of environmentally hazardous chlorocarbons.

Additional components known in the art may be present in the composition including dispersants, stabilizers, release agents, dispersing agents, stripping agents, antifoaming agents and wetting agents. A general disclosure of suitable materials is presented in U.S. Patent No. 5,049,480, which is incorporated herein.

### Applications

### Tape Preparation

The composition(s) of the present invention are used to form a film as a wet slurry or "slip" on a suitable backing materials. The material which is often used for the backing is "mylar". Other possible backing materials might be polypropylene, nylon, and although not narrowly critical to the application of the present invention, should have suitable properties to allow the satisfactory practice of the present invention. For example, the tape on the backing material after drying (the film when dried to remove the solvent is called "the tape") should have sufficient adhesion to the backing to stick together and not "delaminate" through the hot roll lamination step, but should easily come apart once the hot roll lamination step has been completed.

A conformable entity is defined as any structure comprising the composition of the present invention that allows for hot roll lamination. We will discuss the conformable entity in general terms of tape formation. To form the tape, a slip is prepared and used for tape casting. Slip is a general term used for the composition in tape making and is a properly dispersed mixture of inorganic powders dispersed in an organic medium.

Although it is not narrowly critical to the practice of the present invention, a common way of achieving a good dispersion of inorganic powders in the organic medium is by using a conventional ball-milling process. A ball milling consists of ceramic milling jar and milling media (spherical or cylindrical shaped alumina or zirconia pellets). The total mixture is put into the milling jar containing the milling media. After closing the jar with a leak-tight lid, it is tumbled to create a milling action of the milling media inside the jar at a rolling speed at which the mixing efficiency is optimized. The length of the rolling is the time required to attain well-dispersed inorganic particles to meet the performance specifications. Generally, a milling or mixing time of 1-20 hours is sufficient to result in the desired level of dispersion. The slip may be applied to a backing by a blade or bar coating method, followed by ambient or heat drying. The coating thickness after drying may range from a few microns to several tens of microns depending on the end application in which the tape will be used.

The conformable photosensitive dielectric "green" (i.e., "unfired") tape(s) for use in the present invention are formed by casting a layer of desired thickness of a slurry dispersion of inorganic binder, optional ceramic solids, polymeric binder, plasticizer, photoinitiator, photohardenable monomer, and solvent as described above onto a flexible backing and air drying or heating the cast layer to remove the volatile solvent. The backing may be made from a multitude of flexible materials, but is typically Mylar. The tape (coating + e.g., Mylar backing) may then be formed into sheets or collected in a roll form, and sized according to the dictates of the final application for which the tape is intended to be used. (NOTE: Once the tape has been applied to the rigid substrate by hot roll lamination, the backing is generally removed and discarded.)

In the method(s) of present invention, the backing material will usually remain together with the photosensitive ceramic-containing tape through the hot roll lamination stage and removed prior to exposure of the photosensitive tape. In the case where the backing material is a clear transparent. Mylar, or other suitable material which allows exposure to UV actinic light, the backing material could remain on the tape surface even through exposure to the actinic UV light, for example to provide protection of the surface from unwanted contaminations. In this case, the transparent backing material would be removed just before the development step.

It is preferred that the dried tape not exceed a thickness of 65-75 mils. Thicker tapes will often create problems during the firing step when using conventional belt furnaces with total firing cycle times of 30-60 minutes (defined as total time above 100 deg C). In cases where thicker films are required by the application, it would be possible to circumvent the firing sensitivity by using an elongated firing profile not practically feasible for many hybrid circuit manufacturers.

Additionally, a cover sheet may be applied to the tape before it is wound as a "widestock" (master) roll. Examples of typical coversheets include, mylar, silicone coated mylar (terephthalate PET), polypropylene, and polyethylene, or nylon. Typically, the coversheet is removed just before hot roll lamination to the final rigid substrate.

### Suitable Dimensionally Stable Substrates

A "dimensionally stable substrate" as described in the present invention is any solid material, including solid materials comprising ceramic, glass, and metal, which does not noticeably change shape or size under the firing conditions required to sinter and bond the film materials of the present invention to the substrate. Suitable dimensionally stable substrates might include, but are not limited to, conventional ceramics such as alumina, α-quartz, CaZrO₃, mullite, cordierite, forsterite, zircon, zirconia, BaTiO₃, CaTiO₃, MgTiO₃, SiO₂, glass-ceramics, and glasses (amorphous structures, e.g., comprised of soda lime glass or higher melting amorphous structures), amorphous silica or mixtures thereof. Other suitable dimensionally stable substrate materials might be stainless steel, iron and its various alloys, porcelainized steel, other base metals such as nickel, molybdenum, tungsten, copper, as well as platinum, silver, palladium, gold and their alloys, or other precious noble metals and their alloys, and other metal substrates determined to be suitable based on their final application. In particular, one iron alloy that is a suitable substrate is Kovar® (Ni-Fe alloy) substrate. The tape can also be laminated to other electrical substrate assemblies already formed (fired), in order to customize the electrical circuit functionality further. Such substrates might be ceramic hybrid microelectronic circuits already fired on alumina, or circuits comprised of 951 "Green Tape™", 943 "Green Tape™" (both by E.I. du Pont de Nemours and Company), or other LTCC circuits which are now commercially available.

### Customization Of Ceramic Objects and Other Dimensionally Stable Substrates

It is possible to provide novel and otherwise difficult to achieve customization of suitable dimensionally stable substrates using the compositions and methods described in the present invention. A fired image may be created on a dimensionally stable substrate by merely coating the substrate with the conformable photosensitive tape and removing the mylar backing film, or, for more complex structures, coating the dimensionally stable substrate with the slip (slurry) before the solvent is dried off, then printing or otherwise applying an opague image, thus providing a means to limit actinic radiation exposure to only desired areas on the dimensionally stable substrate. If the surface topography of the dimensionally stable substrate is suitable, a "UV mask" containing a UV opaque image, might be applied directly onto the tape or coated substrate. The image would then be formed by exposing the desired tape areas and developing the unexposed tape areas, thus forming the desired pattern, and firing the patterned substrate to form a fired image. This technique for applying images may be useful in electronic applications, as well as general applications, including custom designs difficult to form on ceramic or other dimensionally stable substrates and structures by other available means. Using the methods described above, it is possible to create unique and permanent ceramic-based custom photographic images directly on to ceramic or metal dimensionally stable substrates, which have excellent resolution, and could be used for decorative art or electronic applications. For example, if it were advantageous to identify substrates with a permanent logo which might need to be regularly altered using the benefits of photo imaging (e.g., to identify production lot numbers with the company logo), the materials and methods described herein could be employed. Other applications might be to give electronic circuit elements a unique identification code, such as part number, run number within a lot and/or number of the production lot.

The inherent ease of processing (lamination, photo patterning) of the present invention makes it possible to apply the photo sensitive "green" (unfired) films to a wide variety of dimensionally stable substrate (DSS) materials to achieve unique photo patterned signature art forms. Since the patterning is capable of resolving "gray scale," making the patterning art work from simple photocopies on mylar, it is possible to use the photo imageable films of the present invention to create photograghic images or designs with the topography, hence creating a three dimensional effect. The physical characteristics of the DSS material can be used to help accentuate the three dimensional effects, using the DSS's reflectivity, background color, visible light absorbancy, transparency and texture. For example, using a gold conductor, fired on the DSS substrate, as the substrate's coating creates an antiquing photographic effect, reminiscent of early photographic technology, but with much enhanced image resolution, and adding the permanence of an image fired on to a durable substrate material.

Thus, in the manner described above, a structure may be formed which comprises a dimensionally stable substrate and at least one layer formed from the castable photosensitive dielectric composition described herein. This structure is formed when the castable photosensitive dielectric composition has been processed to volatilize the organic binder and sinter the glass composition.

### Multilayer Circuit Formation

The multilayer electric circuit is formed by supplying a dimensionally stable substrate, which can be any substrate compatible with the thermal coefficient of expansion (TCE) of the conformable photosensitive dielectric tape after it has been fired on to the substrate material. Examples of dimensionally stable substrates include, but are not limited to, alumina, glass, ceramic, α-quartz, CaZrO₃, mullite, cordierite, forsterite, zircon, zirconia, BaTiO₃, CaTiO₃, MgTiO₃, SiO₂, amorphous silica or mixtures thereof. Other suitable substrate materials might be stainless steel, iron and its various alloys, porcelainized steel, other base metals such as nickel, molybdenum, tungsten, copper, as well as platinum, silver, palladium, gold and their alloys, or other precious noble metals and their alloys, and other metal substrates determined to be suitable based on their final application. The tape can also be laminated to other electrical substrate assemblies already formed (fired), in order to customize the electrical circuit functionality further. Such substrates might be ceramic hybrid microelectronic circuits already fired on alumina, or circuits comprised of 951 "Green Tape™", 943 "Green Tape™" (available from E.I. du Pont de Nemours and Company), or other LTCC circuits which are now commercially available.

The dimensionally stable substrate is then optionally coated with a functional or conductive layer, applied in the desired pattern by conventional screen printing or by commercially available photo definition techniques (e.g., Fodel® silver paste, product number 6453 from the E.I. du Pont de Nemours and Company. The conductive paste is typically dried at a suitable temperature to remove all solvent before proceeding. For the first metallization layer on the rigid substrate, the functional conductive film must be fired before applying the photosensitive dielectric tape layer.

Next, the photosensitive dielectric "green" tape is hot-roll laminated to the dimensionally stable substrate. The photosensitive tape is then exposed in the desired pattern thus creating crosslinked or polymerized areas where actinic radiation was applied and uncrosslinked or unpolymerized areas, where the light was not applied. The uncrosslinked (unpolymerized) areas are then washed off using a dilute solution of 0.4-2.0% by weight of sodium or potassium carbonate, thus forming the desired pattern of vias or other desired structures (e.g. cavities, steps, walls). The e.g., vias may then be filled with a conductive metallization. Next, patterned functional conductive layer(s) (additional metallization layers) may be coated on the via filled tape layer to form a circuit assembly. After the first dielectric assembled layer has been fired, the process steps may be repeated as needed or desired, i.e., from the photosensitive tape hot-roll lamination to the functional layer coating, firing each assembled dielectric tape layer before proceeding to the next layer.

The interconnections between layers are formed by filling the via holes with a thick film conductive ink. This ink is usually applied by standard screen printing techniques. Each layer of circuitry is completed by screen printing conductor tracks. Also, resistor inks or high dielectric constant inks can be printed on selected layer(s) to form resistive or capacitive circuit elements.

As used herein, the term "firing" means heating the assembly in an oxidizing atmosphere such as air to a temperature, and for a time sufficient to volatilize (burn-out) all of the organic material in the layers of the assemblage to sinter any glass, metal or dielectric material in the layers and thus densify the entire assembly. Firing is typically performed in a belt furnace, such as manufactured by Sierra Therm, BTU, and Lindberg, among others.

The term "functional layer" refers to the conductive composition applied by screen printing, stenciling ink jetting or other methods to the tape, which has already been hot roll laminated to the dimensionally stable substrate. The functional layer can have conductive, resistive or capacitive functionality. Thus, as indicated above, each typical unfired tape layer may have printed thereon one or more combinations of resistor, capacitor, and/or conductive circuit elements, which will become functional once the assembly has been fired.

### EXAMPLES

For Examples 1-10 and Example 12, the tape thickness of the dried photosensitive film was typically 65-85 microns. Tables 4-7 and Table 9 detail the compositions used in each Example. Table 8 and 10 detail the results of the Examples.

**Table 4: Glass Compositions in Weight Percent Total Glass Composition**

| Ingredients | Glass A | Glass B | Glass C |
|---|---|---|---|
| PbO | 17.2 | 0 | 0 |
| SiO2 | 56.5 | 38.64 | 7.11 |
| B2O3 | 4.5 | 0 | 8.38 |
| Na2O | 2.4 | 0 | 0 |
| K2O | 1.7 | 0 | 0 |
| MgO | 0.6 | 0 | 0 |
| CaO | 8 | 14.76 | 0.53 |
| Al2O3 | 9.1 | 0 | 2.13 |
| BaO | 0 | 12.66 | 0 |
| ZrO2 | 0.0 | 2.5 | 0.0 |
| ZnO | 0 | 29.97 | 12.03 |
| P2O5 | 0 | 1.45 | 0 |
| Bi2O3 | 0 | 0 | 69.82 |

**Table 5: Solids Composition in Weight Percent Total Composition**

| Ingredients | Solids A | Solids B | Solids C |
|---|---|---|---|
| Glass A | 27.6 | 0 | 0 |
| Glass B | 0 | 42.2 | 0 |
| Glass C | 0 | 0 | 49 |
| Alumina | 21.7 | 18.9 | 16.3 |
| Cobalt Aluminate | 0.3 | 0.2 | 0 |

**Table 6: Polymer Composition (Weight Percent of Total Polymer Composition) and Characteristics**

| | **Polymer** | | | | | |
|---|---|---|---|---|---|---|
| **Patent Examples Cross Reference** | **A** | **B** | **C** | **D** | **E** | **F** |
| **Methyl Methacrylate** | 21 | 38 | 35 | 80 | 75 | 70 |
| **Methylacrylic Acid** | 21 | 24 | 21 | 20 | 25 | 20 |
| **Ethyl Acrylate** | 38 | 38 | 19 | x | x | x |
| **Butyl Acetate** | x | X | x | x | x | 10 |
| **Styrene** | 20 | X | x | x | x | x |
| **n-Butyl Methyl Acrylate** | x | X | 25 | x | x | x |
| **Acid Number** | 135 | 145 | 130 | 118 | na | na |
| **Glass Transition Point, Tg** | 80 | 91 | 92 | 105 | na | na |
| **Molecular Weight (x10**^{**3**}**)** | 68 | 57 | 80 | 7 | 28 | 21 |

**Table 7: Composition of Examples (Weight Percent Total Composition)**

| Example Number | 1 | 2 | 3 | 4 | 5 | 6 |
|---|---|---|---|---|---|---|
| Solids A | 49.6 | 0 | 0 | 0 | 0 | 0 |
| Solids B | 0 | 61.3 | 61.3 | 61.3 | 61.3 | 61.3 |
| Solids C | 0 | 0 | 0 | 0 | 0 | 0 |
| Polymer A | 10.12 | 3 | 0 | 0 | 0 | 0 |
| Polymer B | 0 | 0 | 0 | 3 | 0 | 10 |
| Polymer C | 0 | 0 | 0 | 0 | 3 | 0 |
| Polymer D | 0 | 9.1 | 10 | 9.1 | 9.1 | 0 |
| Polymer E | 0 | 0 | 0 | 0 | 0 | 0 |
| Polymer F | 0 | 0 | 0 | 0 | 0 | 0 |
| SR508 | 5.8 | 0 | 0 | 0 | 0 | 0 |
| CD582 | 0 | 4.6 | 3 | 4.6 | 4.6 | 3 |
| Irgacure® 369 | 0.02 | 0.27 | 0.25 | 0.27 | 0.27 | 0.25 |
| Benzoflex® 400 | 1.92 | 2.3 | 6.2 | 2.3 | 2.3 | 6.2 |
| Benzoflex® 200 | 0 | 0 | 0 | 0 | 0 | 0 |
| Malonic Acid | 0 | 0.14 | 0.14 | 0.14 | 0.14 | 0.14 |
| Ethyl Acetate | 32.54 | 19.3 | 19.1 | 19.3 | 19.3 | 19.1 |
| Acetone | 0 | 0 | 0 | 0 | 0 | 0 |
| total | 100.0 | 100.0 | 100.0 | 100.0 | 100.0 | 100.0 |

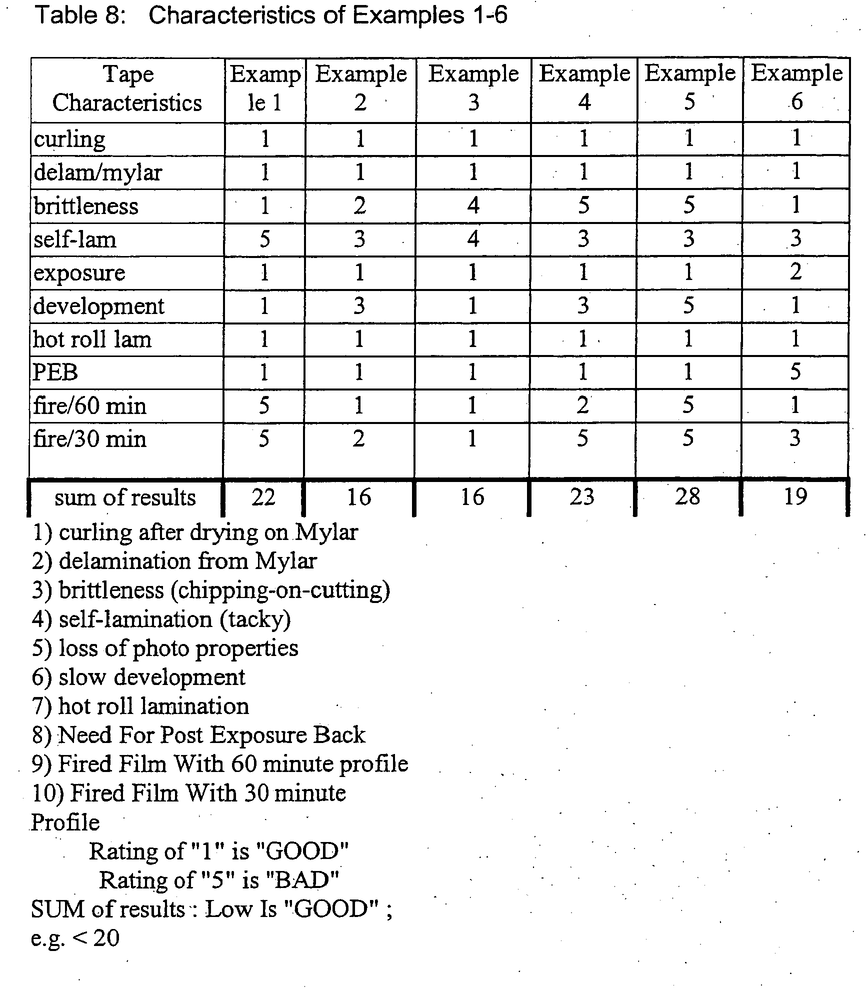

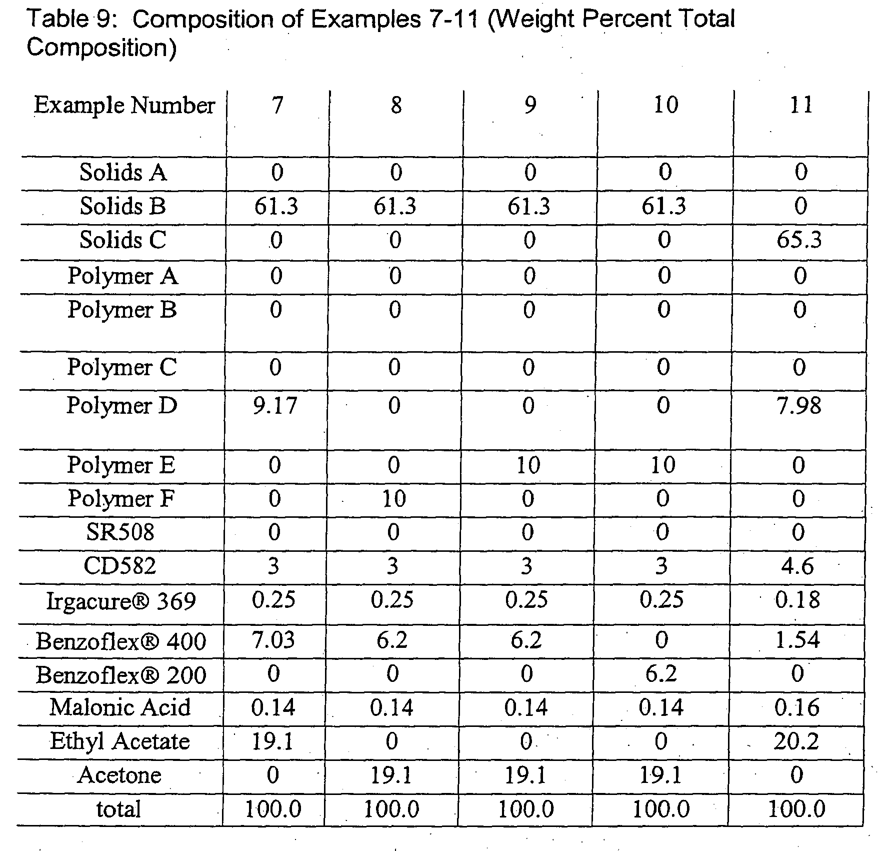

**Table 10: Characteristics of Examples 7-11**

| Tape Characteristics | Example 7 | Example 8 | Example 9 | Example 10 | Example 11 |
|---|---|---|---|---|---|
| curling | 1 | 1 | 5 | 1 | 1 |
| delam/mylar | 1 | 1 | 5 | 1 | 1 |
| brittleness | 1 | 3 | 5 | 2 | 4 |
| self-lam | 5 | 3 | 1 | 2 | 4 |
| exposure | 1 | 1 | 5 | 1 | 1 |
| development | 1 | 1 | 5 | 1 | 1 |
| hot roll lam | 1 | 1 | 5 | 1 | 1 |
| PEB | 1 | 1 | 5 | 1 | 1 |
| fire/60 min | 1 | 1 | 5 | 1 | 1 |
| fire/30 min | 2 | 2 | 5 | 2 | 1 |
| Sum of results | 15 | 15 | 46 | 13 | 16 |

| | | | | | |
|---|---|---|---|---|---|
| 1) curling after drying on Mylar | | | | | |
| 2) delamination from Mylar | | | | | |
| 3) brittleness (chipping-on-cutting) | | | | | |
| 4) self-lamination (tacky) | | | | | |
| 5) loss of photo properties | | | | | |
| 6) slow development | | | | | |
| 7) hot roll lamination | | | | | |
| 8) Need For Post Exposure Bake (PEB) | | | | | |
| 9) Fired Film With 60 minute profile | | | | | |
| 10) Fired Film With 30 minute Profile Rating of "1" is "GOOD" Rating of "5" is "BAD" SUM of results : Low Is "GOOD" ; e.g. < 20 | | | | | |

### Example 1

An adhesive layer of photosensitive tape formed from the composition of Example 1 described above, and as described in Tables 4-7 (and prepared as described above under Tape Preparation) was first hot roll laminated at a lamination temperature of 85-120°C and 0.2-0.4 m/min throughput speed with air assist deactivated (DuPont LC-2400 Hot Roll Lamination machine) to the substrate (3" X 3" 96% alumina substrate commercially available from the COORS Corporation.). This adhesive layer was not exposed, but is used as the "Adhesive" for the second layer. Next, a second layer of the tape composition (65 microns), as described above Example 1, which was covered with a 1 mil mylar cover sheet (flexible backing), was hot roll laminated over the first adhesive layer. The second layer of tape was exposed to actinic radiation (OAI Mask Aligner, Model J500, using a 500 watt UV mercury short arc bulb), through a patterned image (glass phototool) for approximately 8-9 seconds (bulb output = 7-10 mwatts/cm² measured with an International Light, Model IL1400A radiometer with a XRL140A photodetector, measuring in the UVA band at 315-400 nm). The exposed substrate was then subjected to a post-exposure bake in air at approximately 150°C for 2 minutes. After the post-exposure bake the mylar cover sheet was removed. The tape was then developed in an aqueous base solution of 1% sodium carbonate at approximately 85°F at a development speed of 3.7-4.0 ft/min. This was accomplished using an Advanced Systems Incorporated (ASI) Model 757/857 Developer/Rinse System at 25 p.s.i. nozzle pressure with a fan spray configuration. The tape characteristics observed are detailed in Table 8. This example shows that it is not possible to achieve suitable performance capability because of excessive self-lamination and extremely poor firing sensitivity, due to the high monomer level and low plasticizer level.

NOTE: The exposure time (energy) required, depends on the feature sizes being exposed and the light absorption characteristics of the phototool being used (e.g., glass type, Mylar grade, etc).

### Example 2

A layer of the tape formed from the composition of Example 2 (Table 4-7) was hot roll laminated (as described in Example 1), with air assist activated, to the substrate. Note: Air assist was "activated" for all the remaining examples. (The substrate was 96% alumina as in Example 1). The photosensitive tape in this case did not contain a cover sheet, but was on a mylar backing, as in Example 1. The photosensitive tape was then exposed to actinic radiation through a patterned image on mylar for approximately 4-10 seconds. (In this case and for all other examples, the exposure unit was an ORIEL Model 82430 using a 1000 watt mercury-xenon lamp, with an output set at 14.5 mwatts/cm² measured as described above.) The exposed tape on the alumina substrate was then developed in an aqueous base solution of 1% sodium carbonate at approximately 85°F at a development speed of 1.0 ft/min. The tape characteristics observed are detailed in Table 8. This composition had excellent performance with hot roll lamination, gave good firing capability but gave poor development speed and poor wash out of photo-defined features.

### Example 3 (Tables 4- 8)

A layer of the tape formed from the composition of Example 3 was hot roll laminated to the substrate (96% alumina as described above in Examples 1 and 2. This type of alumina substrate was also used for Examples 4-10). The photosensitive tape contained no cover sheet. No cover sheet was used for the remaining examples. The tape was then exposed to actinic radiation through a patterned image on mylar for approximately 3-5 seconds. The exposed substrate/tape was then developed in an aqueous base solution of 1% sodium carbonate at approximately 85°F at a development speed of 2-3 ft/min. The tape characteristics observed are detailed in Table 8. Although this example shows one of the best balances in overall performance, the self-lamination tendency might be improved. One way that self-lamination could be removed as an issue is by the use of an organic cover sheet. Although this is technically feasible, from a practical standpoint, it is less advantageous because it adds cost to the overall manufacturing.

### Example 4 (Tables 4- 8)

A layer of the tape formed from the composition of Example 4 was hot roll laminated to the 96% alumina substrate. The tape was then exposed to actinic radiation through a patterned image on mylar for approximately 4-5 seconds. The exposed tape on substrate was then developed in an aqueous base solution of 1% sodium carbonate at approximately 85°F at a developrrient speed of approximately 2 ft/min. The tape characteristics observed are detailed in Table 8. This composition had extreme brittleness due to an insufficient plasticizer level (2.3%).

### Example 5 (Tables 4- 8)

A layer of the tape formed from the composition of Example 5 was hot roll laminated to the alumina substrate. The tape was then exposed for 3-5 seconds to actinic radiation through a patterned image on mylar. The exposed tape on alumina substrate was then developed in an aqueous base solution of 1 % sodium carbonate at approximately 85°F at 1.8 ft/min. The tape characteristics observed are detailed in Table 8. Even though Examples 4 and 5 are only different by the chemistry of the longer chain polymer which was added, this example was rated poor for brittleness, development and firing capability, showing that the chemistry of the polymer mix can have a significant effect on the overall performance.

### Example 6 (Tables 4- 8)

A layer of the tape formed from the composition of Example 6 was hot roll laminated to the alumina substrate. The tape was then exposed to actinic radiation through a patterned image on mylar for approximately 3-5 seconds. The exposed substrate/tape was then subjected to a post-exposure bake at approximately 150°C for 2 minutes. Next, the exposed substrate/tape was developed in an aqueous solution of 1% sodium carbonate at approximately 85°F at a development speed of 2.3-2.5 ft/min.

For this composition, although the tape film had excellent flexibility due to the long chain polymer content, post exposure bake was required to eliminate surface damage during the development step. Post exposure bake is generally viewed as an added process step, which will adversely affect the customer's throughput and manufacturing cost.

### Example 7 (Tables 4 - 6, 9, 10)

A layer of the tape formed from the composition of Example 7 was hot roll laminated to the alumina substrate. The tape was then exposed to actinic radiation through a patterned image on mylar for approximately 3-5 seconds. The exposed tape on alumina substrate was then developed in an aqueous solution of 1% sodium carbonate at approximately 85°F at a development speed of 2-3 ft/min. The tape characteristics observed are detailed in Table 10. This composition had higher plasticizer level than Example 3, and increased the tendency to self-laminate to an unacceptable level. Other performance characteristics were acceptable.

### Example 8 (Tables 4 - 6, 9, 10)

A layer of the tape formed from the composition of Example 7 was hot roll laminated to the alumina substrate. The tape was then exposed to actinic radiation through a patterned image on mylar for approximately 3-5 seconds. The exposed tape on alumina substrate was then developed in an aqueous solution of 1 % sodium carbonate at approximately 85°F at a development speed of 2-3 ft/min. The tape characteristics observed are detailed in Table 10. The composition of Example 8 used a different polymer than Example 7, and uses acetone as the solvent. It gave slightly better flexibility and slightly less brittleness. All other performance characteristics were acceptable.

### Example 9 (Tables 4- 6, 9,10)

The composition of Example 9 was extremely brittle after casting on the mylar backing film and dried. It lost adhesion to the mylar backing film and was unable to be processed further. The composition of Example 9 used another polymer described in Tables 4-6 and 9, which had a different chemistry and slightly higher molecular weight than the polymer in Example 8, however, the tape film characteristics overall were much worse than Example 8.

### Example 10 (Tables 4 - 6, 9,10)

A layer of the tape formed from the composition of Example 10 was hot roll laminated to the alumina substrate. The tape was then exposed to actinic radiation through a patterned image on mylar for approximately 1.5-2.5 seconds. The exposed tape on alumina substrate was then developed in an aqueous solution of 1 % sodium carbonate at approximately 85°F at a development speed of approximately 3 ft/min. The tape characteristics observed are detailed in Table 10. The composition of Example 10 was identical to that of Example 9, but with a different plasticizer used. The overall performance of the tape film in this composition was rated one of the best, showing that choice of plasticizer is important, especially in combination with the choice of polymer.

### Example 11 (Tables 4 - 6, 9, 10)

The purpose of Example 11 was to show that the process and formulation of the present disclosure can be successfully applied to other glass chemistries and therefore, could be used for other end use applications. In Example 11, a layer (dried tape thickness = 12 microns) of the tape formed from the composition of Example 11 (see Tables 4-6, 9 and 10) was hot roll laminated to the glass substrate (microscope slide composed of soda lime glass). The tape was then exposed to actinic radiation through a patterned image on mylar for approximately 2-4 seconds. The exposed tape on soda lime glass substrate was then developed in an aqueous solution of 1 % sodium carbonate at approximately 85°F with a development speed of 4-6 ft/min. The tape characteristics observed are detailed in Table 10.

The composition of Example 11 shows that this photo imaging technology can be applied broadly to other tape solids and glass chemistries, such as those that might be employed and required in applications such as Plasma Display Panels and Field Emission Displays.

### Example 12 (Comparative Example from Suess, EP0589241, Example 13)

The individual components of the composition of Example 12, as detailed in the Suess patent, EP0589241, Example 13, were added to a milling apparatus containing Zirconia mill media and milled for 2.5 hours (with a slow roll time of 50 minutes). The composition was removed from the milling apparatus, cast, and dried overnight under a hood. The tape was much to sticky, causing unacceptable packaging, handling and processing problems (i.e., it stuck to itself in the stack, roll, phototool, etc). Also, Hot Roll Lamination (HRL) performance was poor. A layer of the tape formed from the composition of Example 12, was hot roll laminated at 85-110°C at 0.2 to 0.3 m/min, to the alumina substrate. Delamination at the edge of the coating was observed, in spite of the severe self-lamination tendency, also observed. Parts processed two times the normal HRL process still showed signs of poor lamination when exposed and developed. The tape was then exposed to actinic radiation through a patterned image for approximately 4 seconds. The exposed tape on alumina substrate was then developed at a development speed of 5 feet/minute in an aqueous solution of 1% sodium carbonate at approximately 85°F. Post Exposure Bake was required to reduce the cracking / ripping seen after development. Edge curling seen after firing appears to be a combination of the poor lamination properties along with the tendency of this organic system to curl when heated.

### Example 13

In order to demonstrate the ease, speed and versatility of the invention described in this application, a layer of the tape formed from the composition of Example 3 (Tables 4-7) was hot roll laminated, with air assist activated, to a 4" X 6" 96% alumina substrate. The photosensitive tape was then exposed to actinic radiation through a patterned image formed by photocopying a digital photograph directly on to overhead media ("Mylar"). The image was exposed for approximately 4-10 seconds. The exposed tape on the alumina substrate was then developed in an aqueous base solution of 1% sodium carbonate at approximately 85°F at a development speed of 2.0-3.0 ft/min. The substrate was then fired on a standard 60 minute firing profile in a conventional belt furnace. The fired substrate exhibited excellent reproduction of the original art work pattern.

Using this technology, it would be possible to create a fired image of an existing pattern (photograph, digitalized object, text, pattern, design, etc.) in 2-3 hours. The only limitation is that the pattern must limit exposure of the tape in the desired areas. For example, the image could be formed by simply marking the tape directly with an ink which is sufficient to block exposure in the marked areas. There is no existing technology that offers the ease, speed and versatility of the photo sensitive tape film compositions described in the present invention.

## Claims

1. A castable photosensitive dielectric composition comprising an admixture of:
(a) finely divided particles of inorganic binder; dispersed in an organic composition comprising:
(b) an organic polymeric binder comprising a copolymer, interpolymer or mixtures thereof, wherein each copolymer or interpolymer comprises (1) a nonacidic comonomer comprising a C₁₋₁₀ alkyl acrylate, C₁₋₁₀ alkyl methacrylate, styrenes, substituted styrenes, or combinations thereof and (2) an acidic comonomer comprising ethylenically unsaturated carboxylic acid containing moiety, the copolymer, interpolymer or mixture having an acid content of at least 15% by weight;
(c) plasticizer wherein the ratio of plasticizer to polymer binder is in the range of 4:23 to 7:9;
(d) a photoinitiator;
(e) photohardenable monomer; dissolved in
(f) an organic solvent,
the composition upon imagewise exposure to actinic radiation being developable in a dilute aqueous basic solution containing 0.4 - 2.0 weight % of base.

2. The composition of Claim 1 further comprising ceramic solids.

3. A conformable photosensitive green dielectric tape suitable for hot roll lamination comprising an admixture of:
(a) finely divided particles of inorganic binder; dispersed in an organic composition comprising:
(b) an organic polymeric binder comprising a copolymer, interpolymer or mixtures thereof, wherein each copolymer or interpolymer comprises (1) a nonacidic comonomer comprising a C₁₋₁₀ alkyl acrylate, C₁₋₁₀ alkyl methacrylate, styrenes, substituted styrenes, or combinations thereof and (2) an acidic comonomer comprising ethylenically unsaturated carboxylic acid containing moiety, the copolymer, interpolymeror mixture having an acid content of at least 15% by weight;
(c) plasticizer wherein the ratio of plasticizer to polymer binder is in the range of 4:23 to 7:9;
(d) a photoinitiator; and
(e) photohardenable monomer;
the composition upon imagewise exposure to actinic radiation being developable in a dilute aqueous base solution containing 0.4-2.0 weight % base.

4. The dielectric tape of Claim 3 further comprising ceramic solids.

5. A method for the application of a conformable photosensitive green dielectric tape to a dimensionally stable substrate comprising the sequential steps of:
(a) providing a dimensionally stable substrate;
(b) providing the conformable photosensitive green dielectric tape of Claim 3;
(c) hot roll laminating the conformable photosensitive green tape of (b) to the substrate of (a);
(d) exposing the photosensitive green tape of (c) in a desired pattern thus creating polymerized and unpolymerized areas; and
(e) developing the unexposed tape of (d) thus removing the unpolymerized areas and forming a desired pattern.

6. The method of Claim 5 further comprising the step of firing said desired pattern and substrate.

7. The method of Claim 5 wherein said substrate is selected from the group comprising alumina, silica, glass, quartz, fired dielectric paste, fired dielectric tape, stainless steel, porcelainized steel, iron, alloys of iron, nickel, alloys of nickel, molybdenum, alloys of molybdenum, tungsten, alloys of tungsten, copper, alloys of copper, platinum, alloys of platinum, silver, alloys of silver, palladium, alloys of palladium, gold, alloys of gold, ceramic hybrid microelectronic circuits already fired on alumina, and circuits comprised of dielectric tape.

8. A method of forming an electronic circuit comprising the steps of:
(a) providing a dimensionally stable substrate;
(b) providing the conformable photosensitive green dielectric tape of Claim 4;
(c) hot roll laminating the photosensitive green tape of (b) to the substrate of (a);
(d) exposing the photosensitive green tape of (c) in a desired pattern thus creating polymerized and unpolymerized areas; and
(e) developing the unexposed film of (d) thus removing the unpolymerized areas and forming a desired pattern.

9. The method of Claim 8 wherein said electronic circuit is a multilayered electronic circuit.

10. A multilayered electronic circuit formed by the method of Claim 9.

11. A structure comprising a dimensionally stable substrate and at least one layer formed from the castable photosensitive dielectric composition of Claim 1, wherein said castable photosensitive dielectric composition has been processed to volatilize the organic binder and sinter the glass composition.

12. A structure comprising a dimensionally stable substrate and at least one layer of the conformable green dielectric tape of Claim 3, wherein said tape has been processed to volatilize the organic binder and sinter the glass composition.

13. The structure of Claim 11 wherein said structure further comprises one or more metallization layers.
